# EUROPEAN PATENT APPLICATION

(11) **EP 4 769 948 A1**
(43) Date of publication of application: **01.07.2026**
(21) Application number: 24876425.0
(22) Date of filing: 27.09.2024
(51) Int. Cl.: H03K 17/687

(54) **SPLIT SWITCH STRUCTURE, RADIO FREQUENCY SWITCH, ELECTRONIC PRODUCT, AND BASE STATION**

(30) Priority: 13.10.2023 CN 202311326509
(71) Applicant: Maxscend Microelectronics Company Limited, Wuxi, Jiangsu 214072 (CN)
(72) Inventor: LI, Boyuan, Wuxi, Jiangsu 214072 (CN); YE, Peng, Wuxi, Jiangsu 214072 (CN); TANG, Zhuang, Wuxi, Jiangsu 214072 (CN)
(74) Representative: Murgitroyd & Company
(86) International application number: PCT/CN2024/121919
(87) International publication number: WO 2025/077608

(57) **Abstract**

The present invention provides a split switch structure, a radio frequency switch, an electronic product, and a base station. The split switch structure includes: a single pole N throw switch, where N is a natural number greater than or equal to 1; the single pole N throw switch includes N switch paths, each switch path is switched through turn-on and turn-off of a switching transistor, and devices of the single pole N throw switch are at least arranged on two chips; and pads corresponding to contacts of the single pole N throw switch satisfy isolation requirements in terms of distance. In the split switch structure and the electronic product of the present invention, splitting devices of a single pole multi-throw switch onto at least two chips reduces chip area and cost, and isolation is improved through flexible spatial arrangement, thereby achieving both high isolation and low cost, thus making it suitable for large-scale production and application.

## Description

### TECHNICAL FIELD

The present invention relates to the field of integrated circuits, and in particular, to a split switch structure, a radio frequency switch, an electronic product, and a base station.

### BACKGROUND

A single pole multi-throw (SPNT) switch is one of the most commonly used devices in the field of circuits, especially widely applied in fields such as communications, radar, and electronic countermeasures. The single pole multi-throw switch enables switching between different paths.

The existing single pole multi-throw switch is disposed on a chip. In order to improve isolation, pads of the single pole multi-throw switch need to be spaced as far apart as possible, which leads to a relatively large chip size for fabricating the single pole multi-throw switch and correspondingly increases cost. Conversely, in order to reduce cost by minimizing chip area, isolation between signals becomes insufficient.

Therefore, how to propose a single pole multi-throw switch that achieves both high isolation and low cost has become one of the urgent problems to be solved by those skilled in the art.

It should be noted that the introduction of the technical background above is only for the convenience of clear and complete description of technical solutions of the present invention and the understanding of those skilled in the art. These technical solutions described in the background section of the present invention should not be considered as commonly known to those skilled in the art merely because they are presented therein.

### SUMMARY

In view of all the shortcomings of the prior art described above, purposes of the present invention are to provide a split switch structure, a radio frequency switch, an electronic product, and a base station, aiming to solve a problem that it is difficult for a single pole multi-throw switch in the prior art to achieve both high isolation and low cost.

To achieve the above purposes and other related purposes, the present invention provides a split switch structure, and the split switch structure includes:

a single pole N throw switch, where N is a natural number greater than or equal to 1; and the single pole N throw switch includes N switch paths, each switch path is switched through turn-on and turn-off of a switching transistor, and devices of the single pole N throw switch are at least arranged on two chips.

Optionally, the split switch structure further includes a package housing, the single pole N throw switch is arranged within the package housing, and each pad of the single pole N throw switch is electrically connected to a corresponding pin on the package housing.

Optionally, each switch path includes M stages of switching transistors and m stages of pull-down modules, where M is a natural number greater than or equal to 1, and m is a natural number greater than or equal to 0 and less than or equal to M+1; when a number of switching transistors, M, in a switch path is greater than or equal to 2, a switching transistor at each stage is cascaded sequentially; an end of each pull-down module is connected to an end of a corresponding switching transistor, and another end of the pull-down module is grounded or connected to a specific impedance; and a number of switching transistors, M, in each switch path is the same or different, and a number of pull-down modules, m, in each switch path is the same or different.

More optionally, the pull-down module includes P stages of transistors, where P is a natural number greater than or equal to 1, and when P is greater than or equal to 2, a transistor at each stage is connected in series sequentially; and a number of transistors, P, in each pull-down module is the same or different.

More optionally, the switching transistor is an NMOS transistor, and the transistor in the pull-down module is an NMOS transistor.

More optionally, when N is greater than or equal to 2, the N switch paths are arranged on at least two chips, and a same switch path is located on a same chip.

More optionally, n1 switch paths of the single pole N throw switch are arranged on a first chip, and n2 switch paths are arranged on a second chip; and n1 + n2 = N, where n1 is a natural number greater than or equal to 1 and less than N.

More optionally, when n2 is greater than or equal to 2, a number of second chips is set to n2, and taking a switch path as a unit, the n2 switch paths are respectively arranged on n2 second chips in a one-to-one correspondence.

More optionally, at least one of the N switch paths is split into at least two parts, and each part of a same switch path is located on a different chip.

More optionally, n3 switch paths of the single pole N throw switch are arranged on a first chip; n4 switch paths are each divided into a first segment and a second segment, the first segment of each switch path is arranged on the first chip, and the second segment of each switch path is arranged on a second chip; and n3 + n4 = N, where n4 is a natural number greater than or equal to 1 and less than or equal to N.

More optionally, the first segment and the second segment of each switch path are connected in series, and ends of the N switch paths on the first chip are connected together.

More optionally, when N and n4 are both greater than or equal to 2, a number of second chips is set to n4, and taking a switch path as a unit, the n4 switch paths are respectively arranged on n4 second chips in a one-to-one correspondence.

More optionally, a circuit structure on each second chip is identical.

More optionally, pins on the package housing include one antenna pin and N radio frequency pins.

To achieve the above purposes and other related purposes, the present invention provides a split switch structure, including:
a single pole N throw switch, where N is a natural number greater than or equal to 1; where the single pole N throw switch includes N switch paths; and
at least one of the switch paths is located on at least two chips.

More optionally, at least one of the switch paths is located on a same chip.

More optionally, each of the switch paths is located on a different chip.

More optionally, the switch path includes a first chip and a second chip, and a circuit structure of the first chip in different switch paths is identical.

More optionally, the switch path includes a first chip and a second chip, and a circuit structure of the second chip in different switch paths is identical.

More optionally, a circuit structure of each of the switch paths is identical.

More optionally, the N switch paths include a first switch path and a second switch path, and circuit structures of the first switch path and the second switch path are different.

More optionally, each of the chips includes: at least two pads, the pads are configured to electrically connect the chip (a current chip) to another chip (a target chip) or to a package housing.

More optionally, it further includes: a package housing configured to encapsulate the single pole N throw switch within the package housing.

More optionally, the package housing includes: one antenna pin and N radio frequency pins;
the antenna pin is electrically connected to an end of all of the N switch paths; and
the N radio frequency pins are electrically connected to the other ends of the N switch paths in a one-to-one correspondence.

More optionally, it further includes: a metal lead or a substrate, configured to electrically connect different chips.

More optionally, each of the switch paths includes: M switching transistors; and when a number of switching transistors, M, in a switch path is greater than or equal to 2, each switching transistor is cascaded sequentially, where M is a natural number greater than or equal to 1.

More optionally, the switch path further includes: m pull-down modules, where m is a natural number greater than or equal to 0 and less than or equal to M-1; and an end of each pull-down module is connected to an end of a corresponding switching transistor, and another end of the pull-down module is grounded or connected to a specific impedance.

More optionally, the pull-down module includes P transistors, where P is a natural number greater than or equal to 1, and when P is greater than or equal to 2, each transistor is connected in series sequentially.

More optionally, the switching transistor is an NMOS transistor, and the transistor in the pull-down module is an NMOS transistor.

On the other hand, the present invention provides a radio frequency switch, and the radio frequency switch at least includes: the split switch structure described above.

On the other hand, the present invention provides an electronic product, the electronic product at least includes: a data receiving component and a data transmitting component, and both the data receiving component and the data transmitting component include: the radio frequency switch described above.

On the other hand, the present invention provides a base station, the base station is provided with a radio frequency switch unit, and the radio frequency switch unit includes the radio frequency switch described above.

As described above, the split switch structure, the radio frequency switch, the electronic product, and the base station of the present invention have the following beneficial effects.

In the split switch structure of the present invention, a single pole N throw switch, which is traditionally fabricated on one relatively large chip, is split onto at least two chips. Since there is a distance between two chips, overall isolation of the switch is higher. Moreover, during fabrication, there is no need to consider a distance between two pads within a single switch path, thereby reducing overall chip area by minimizing the distance between the two pads within the single switch path. At the same time, because the overall chip area is reduced, cost of chip fabrication is lower. Furthermore, due to reduction in chip size, the chip may be more conveniently placed in suitable positions. An electrical connection between chips is achieved through a metal lead or a substrate, thereby greatly improving flexibility. This further contributes to optimization of indicators such as isolation (when a size of each chip is already determined, a distance between chips may be maximized as needed to achieve higher isolation).

Cost and isolation requirements of the split switch structure of the present invention do not constrain each other, thereby achieving both high isolation and low cost, thus making it suitable for large-scale production and application.

### BRIEF DESCRIPTION OF THE DRAWINGS

FIG. 1 shows a schematic structural diagram of a single pole triple-throw switch chip.
FIG. 2 shows a schematic diagram of a circuit structure of a single pole N throw switch according to the present invention.
FIG. 3 shows a schematic diagram of a splitting method of a single pole N throw switch of the present invention.
FIG. 4 shows a schematic diagram of a split switch structure corresponding to the splitting method of FIG. 3.
FIG. 5 shows a schematic diagram of another splitting method of a single pole N throw switch according to the present invention.
FIG. 6 shows a schematic diagram of a split switch structure corresponding to the splitting method of FIG. 5.
FIG. 7 shows a schematic diagram of still another splitting method of a single pole N throw switch according to the present invention.
FIG. 8 shows a schematic diagram of yet still another splitting method of a single pole N throw switch according to the present invention.
FIG. 9 shows a schematic diagram of a split switch structure corresponding to the splitting methods of FIG. 7 and FIG. 8.

### Description of reference numerals:

- 1: single pole triple-throw switch chip;
- 10: package housing;
- 101, 102, 103, 104: pin;
- 11: chip;
- 12, 13, 14, 15: pad;
- 2: split switch structure;
- 20: package housing;
- 21: single pole N throw switch;
- 211: switching transistor;
- 212: pull-down module;
- 21a: first switch path;
- 21b: second switch path;
- 21c: third switch path;
- 21d: fourth switch path;
- 22: first chip; and
- 23, 23a, 23b, 23c: second chip.

### DETAILED DESCRIPTION OF THE EMBODIMENTS

The following describes embodiments of the present invention through specific examples, and those skilled in the art may easily understand other advantages and effects of the present invention from the content disclosed in this specification. The present invention may also be implemented or applied through other different specific embodiments, and various details in this specification may also be modified or changed based on different viewpoints and applications without departing from the spirit of the present invention.

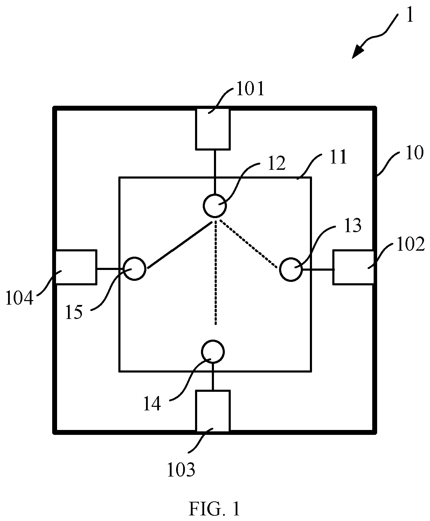

Referring to FIG. 1 to FIG. 9, it should be noted that the drawings provided in this embodiment only illustrate the basic concept of the present invention in a schematic manner. Therefore, the drawings only show components related to the present invention and are not drawn according to the number, shape, and size of components in actual implementation. In actual implementation, the form, quantity, and proportion of each component may be changed arbitrarily, and the layout of components may also be more complex. As shown in FIG. 1, a single pole triple-throw switch chip 1 is shown, where a single pole triple-throw switch is fabricated on a chip 11 within a package housing 10, and four pads 12, 13, 14, and 15 of the single pole triple-throw switch are respectively connected to pins 101, 102, 103, and 104; and a distance between the pads needs to satisfy isolation requirements. In this solution, high isolation leads to large chip area; small chip area leads to poor isolation; and the two factors are mutually constrained. To balance isolation and cost, the distance between the pads may be set to just satisfy the isolation requirements to minimize chip size as much as possible. However, neither isolation nor cost performance is outstanding, thereby making it impossible to achieve both high isolation and low cost.

To achieve both low cost and high isolation, the present invention proposes a split switch structure 2, and the split switch structure 2 includes:
a single pole N throw switch 21, where N is a natural number greater than or equal to 1; the single pole N throw switch 21 includes N switch paths, each switch path is switched through turn-on and turn-off of a switching transistor, and devices of the single pole N throw switch 21 are at least arranged on two chips; and pads corresponding to contacts of the single pole N throw switch satisfy isolation requirements in terms of distance.

Specifically, the single pole N throw switch 21 may be configured as a single pole single-throw switch, a single pole double-throw switch, a single pole triple-throw switch, or a single pole multi-throw switch providing more paths as needed.

Specifically, in an example, each chip of the single pole N throw switch 21 may be used as an independent entity in a circuit, that is, each pad of the single pole N throw switch 21 is directly electrically connected to other devices without the need to connect to a package pin (i.e., a radio frequency pin or an antenna pin). In another example, each chip of the single pole N throw switch 21 is packaged within a package housing 20 and used as a whole in the circuit. In this case, the split switch structure 2 also includes the package housing 20, the single pole N throw switch 21 is disposed within the package housing 20, and each pad of the single pole N throw switch 21 is electrically connected to a corresponding pin on the package housing 20. In this embodiment, pins on the package housing 20 include one antenna pin ANT and N radio frequency pins RF1, RF2... RFN, that is, N radio frequency channels share one antenna through time division multiplexing. Each pin is electrically connected to a corresponding pad through a packaging method such as a metal lead or a substrate. In practical use, an application scenario of the split switch structure 2 may be configured as required, and definitions of each pin may be configured accordingly, which is not limited to this embodiment.

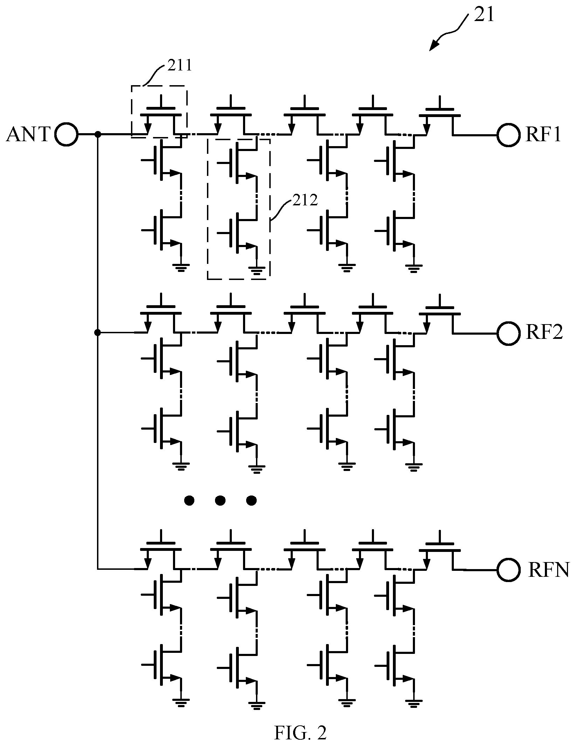

Specifically, as shown in FIG. 2, in this embodiment, each switch path includes M stages of switching transistors 211 and m stages of pull-down modules 212, where M is a natural number greater than or equal to 1, and m is a natural number greater than or equal to 0 and less than or equal to M+1. When a number of switching transistors 211, M, in a switch path is greater than or equal to 2, a switching transistor 211 at each stage is cascaded sequentially. The number of the switching transistors 211, M, is determined based on design requirements. An end of each pull-down module 212 is connected to a connection node of a corresponding switching transistor 211 (the pull-down module may be set at an input end and/or an output end of each switching transistor), and another end of each pull-down module 212 is grounded or connected to a specific impedance (an impedance value is set as needed). The pull-down module 212 is configured to improve isolation between switch paths (when a current switch path is turned off, a connection node between the switching transistors is configured to a preset potential). A number of pull-down modules 212, m, is determined based on design requirements; and the larger m is, the higher the isolation between channels is. The number of the switching transistors 211, M, in each switch path may be configured to be the same or different; similarly, the number of the pull-down modules 212, m, in each switch path may be configured to be the same or different, as determined based on actual needs. In this embodiment, both a structure and a number of devices in each switch path are the same.

More specifically, as an example, the switching transistor 211 is set as an NMOS transistor, where each NMOS transistor is connected in series sequentially, a drain of an NMOS transistor at a previous-stage is connected to a source of an NMOS transistor at a next-stage. A source of an NMOS transistor at a first-stage is connected to an antenna pin ANT (a movable contact), and a source of an NMOS transistor at a last-stage is connected to a corresponding radio frequency pin (a stationary contact). The pull-down module 212 includes P stages of NMOS transistors, where P is a natural number greater than or equal to 1. When P is greater than or equal to 2, an NMOS transistor at each stage is connected in series sequentially. Each NMOS transistor is connected in series sequentially, a source of an NMOS transistor at a previous-stage is connected to a drain of an NMOS transistor at a next-stage. A drain of an NMOS transistor at a first-stage is connected to a connection node between two adjacent stages of switching transistors, and a source of an NMOS transistor at a last-stage is grounded. A number of cascaded NMOS transistors, P, in the pull-down module 212 is determined based on design requirements. The number of the NMOS transistors, P, in each pull-down module 212 may be configured to be the same or different. In this example, the number of the NMOS transistors, P, in each pull-down module 212 is the same.

It should be understood that the devices may be the aforementioned switching transistors 211 and/or the NMOS transistors in each pull-down module 212.

It should be noted that, in practical use, a structure and device types of each switch path may be set as needed. Any circuit structure capable of implementing a switching operation and meeting signal transmission requirements is applicable to the present invention, which is not limited to this embodiment.

The single pole N throw switch of the present invention is split into at least two parts, and each part is fabricated on a different chip. A splitting method may be set according to actual needs, including but not limited to: when N is greater than or equal to 2, the N switch paths are disposed on at least two chips, and a same switch path is located on a same chip; and at least one of the N switch paths is split into at least two parts, and each part of a same switch path is located on a different chip. A switch control signal for each switch path is provided by a control module, and the control module may be prepared on any one or multiple chips on which the single pole N throw switch is disposed, or may be disposed on other chips.

Several specific implementations of the split switch structure 2 are listed below and explained.

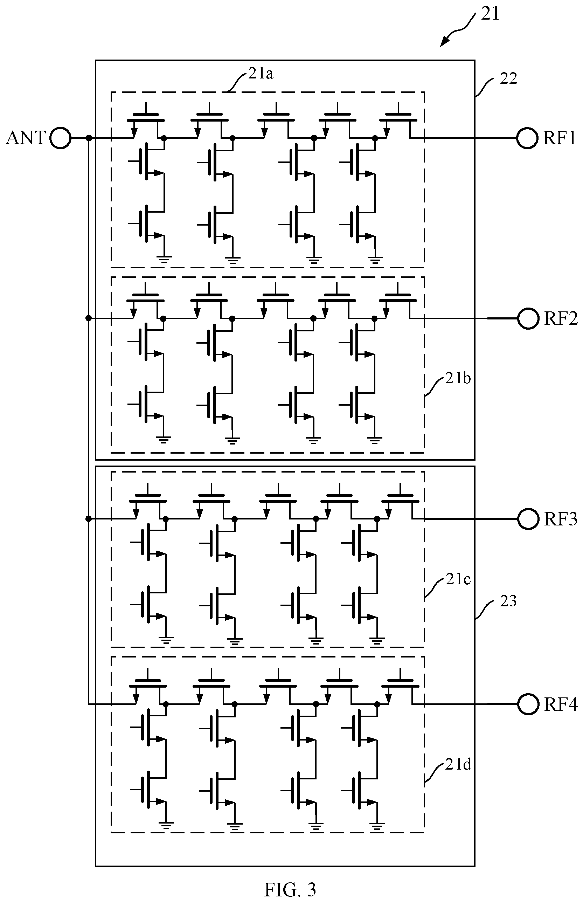

As shown in FIGS. 3 to 6, in this embodiment, n1 switch paths of the single pole N throw switch 21 are arranged on a first chip, and n2 switch paths are arranged on a second chip; and n1 + n2 = N, and n1 is a natural number greater than or equal to 1 and less than N. That is, the switch paths are split as a whole, a part is arranged on the first chip, and another part is arranged on the second chip.

Specifically, when n2 is greater than or equal to 2, the switch paths arranged on the second chip may be further split on a per-switch-path basis, that is, at least two second chips are provided. As an example, a number of second chips is set to n2, and taking a switch path as a unit, the n2 switch paths are respectively arranged on n2 second chips in a one-to-one correspondence.

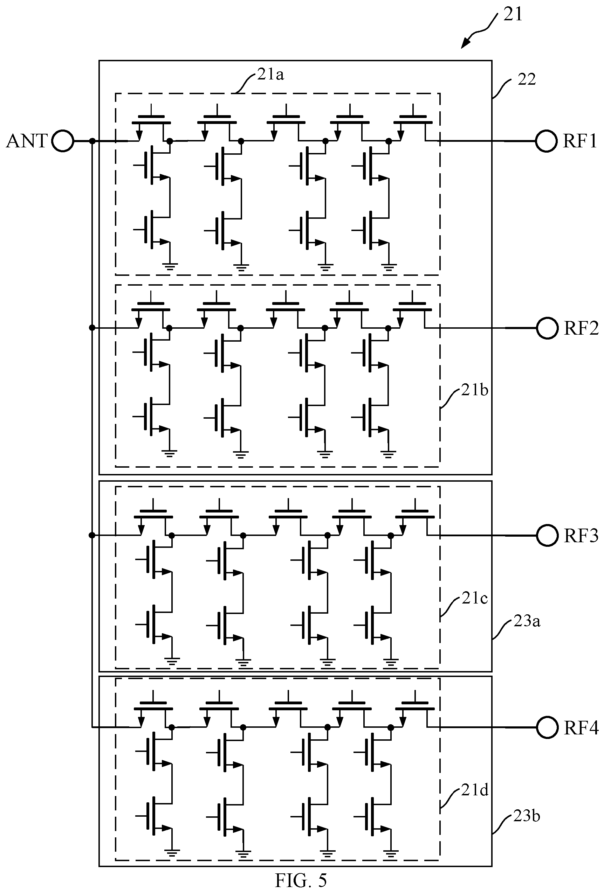

As shown in FIG. 3 and FIG.5, in this embodiment, N is set to 4, n1 is set to 2, and n2 is set to 2. The single pole N throw switch 21 is a single pole quadruple-throw switch, including a first switch path 21a, a second switch path 21b, a third switch path 21c, and a fourth switch path 21d. A structure of each switch path is the same, including five stages of switching transistors and four stages of pull-down modules. A switching transistor at each stage is cascaded sequentially, and a pull-down module at each stage is arranged between two adjacent stages of switching transistors. The pull-down module at each stage includes two cascaded NMOS transistors.

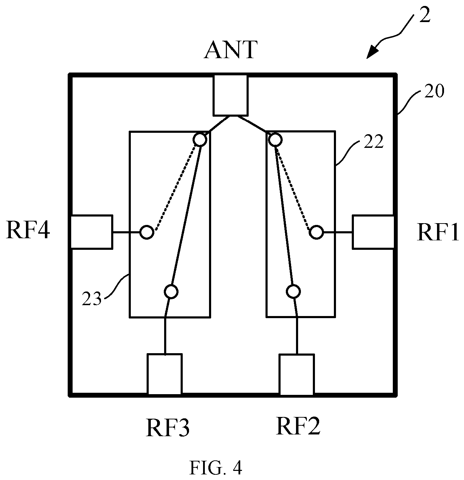

As an example, as shown in FIG. 3, chips on which the single pole quadruple-throw switch is disposed include one first chip 22 and one second chip 23. The first switch path 21a and the second switch path 21b are arranged on the first chip 22, and the third switch path 21c and the fourth switch path 21d are arranged on the second chip 23. As shown in FIG. 4, a movable contact of the single pole quadruple-throw switch is split into two parts, located on the first chip 22 and the second chip 23, respectively. Two movable contacts may be electrically connected via a metal lead or a substrate, or may be directly electrically connected to a corresponding pin via a metal lead or a substrate. Since the four switch paths are split onto two chips, the arrangement of pads is more flexible and isolation requirements are satisfied. A sum of sizes of the first chip 22 and the second chip 23 is less than a size of a chip on which all the four switch paths are disposed, thereby satisfying requirements of cost reduction and isolation assurance.

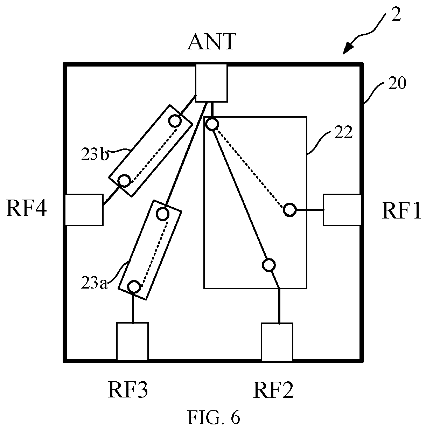

As another example, as shown in FIG. 5, chips on which the single pole quadruple-throw switch is disposed include one first chip 22 and two second chips 23a and 23b. The first switch path 21a and the second switch path 21b are arranged on the first chip 22, the third switch path 21c is arranged on the second chip 23a, and the fourth switch path 21d is arranged on the second chip 23b. As shown in FIG. 6, a movable contact of the single pole quadruple-throw switch is split into three parts, located on the first chip 22, the second chip 23a, and the second chip 23b, respectively. Three movable contacts may be electrically connected via a metal lead or a substrate, or directly electrically connected to a corresponding pin via a metal lead or a substrate. The four switch paths are split onto three chips, thereby achieving requirements of low cost and high isolation.

It should be noted that in the example shown in FIG. 3 and FIG. 4, if the switch paths on the first chip 22 and the second chip 23 have the same structure (both a number of devices and their connection relationships are the same), the first chip and the second chip are of the same type, thereby simplifying a preparation process (only one type of chip needs to be prepared) and reducing inventory pressure. Similarly, in the example shown in FIG. 5 and FIG. 6, the switch paths on the second chips 23a and 23b may also be configured with the same structure. In practical use, a structure of each switch path and a switch path structure on each chip may be set as needed. Additionally, on the basis of this embodiment, each switch path may be further split into at least two segments, each segment is disposed on a different chip (for example, a third chip, a fourth chip...), thereby further improving flexibility and reducing cost, and details are not repeated here.

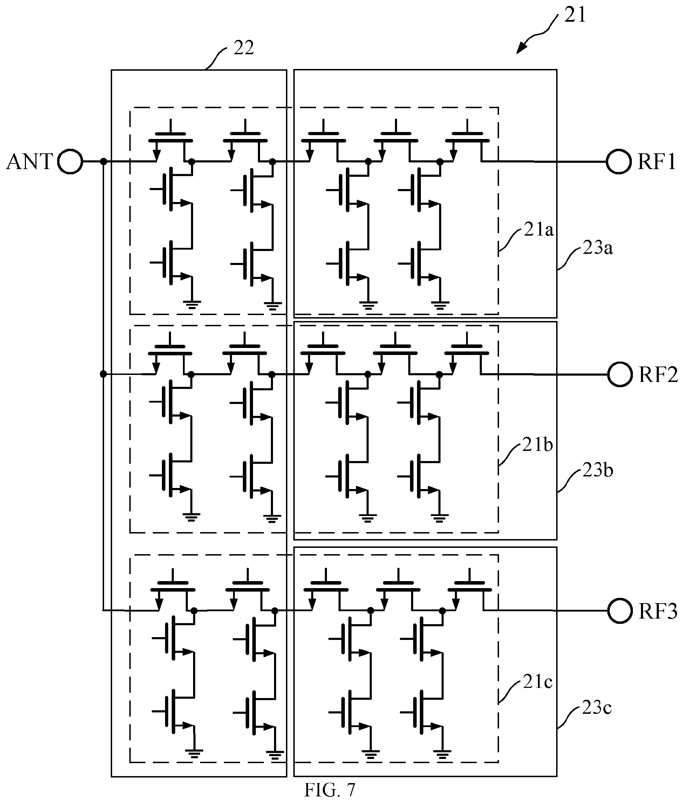

Based on the above embodiments, in an embodiment of this specification, as shown in FIGS. 7 to 9, n3 switch paths of the single pole N throw switch 21 are arranged on the first chip; n4 switch paths are each divided into a first part (including at least one device) and a second part (including at least one device), where the first part of each switch path is arranged on the first chip, and the second part of each switch path is arranged on the second chip; and n3 + n4 = N, and n4 is a natural number greater than or equal to 1 and less than or equal to N (when N = 1, n3 = 0 and n4 = 1). That is, at least one switch path is split into two parts, and the two parts are arranged on different chips.

Specifically, in this embodiment, each switch path is divided into a first segment and a second segment (two parts), and each of the first segment and the second segment is a continuous circuit structure. In each switch path, the first segment and the second segment are connected in series. Ends of the N switch paths on the first chip are connected together. That is, one switch path is split into two continuous parts, and a complete switch path is obtained by connecting the first part and second part in series. In practical use, the first part and the second part may be configured as discontinuous circuit structures. For example, one switch path is divided into three segments in cascade order, where a front segment belongs to a first part, a middle segment belongs to a second part, and a rear segment belongs to a first part. In this case, additional pads and metal leads are needed to achieve electrical connection of the switch path, but purposes of low cost and high isolation can still be achieved.

Specifically, when N and n4 are both greater than or equal to 2, the switch paths arranged on the second chip may be further split on a per-switch-path basis, that is, at least two second chips are provided. A number of second chips is set to n4, and taking a switch path as a unit, the n4 switch paths are respectively arranged on n4 second chips in a one-to-one correspondence.

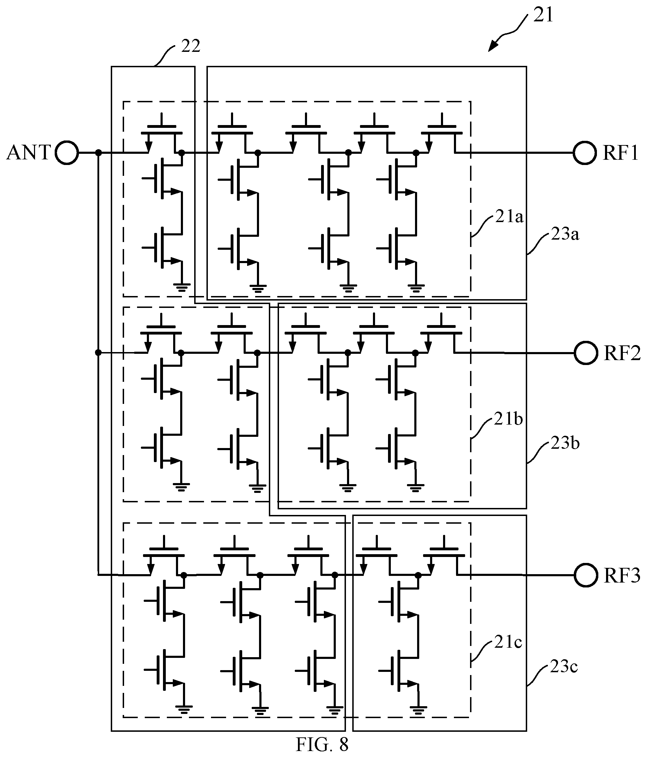

As shown in FIG. 7 and FIG.8, in this embodiment, N is set to 3, n3 is set to 0, and n4 is set to 3. The single pole N throw switch 21 is a single pole triple-throw switch, including a first switch path 21a, a second switch path 21b, and a third switch path 21c. Each switch path has the same structure, each switch path includes five stages of switching transistors and four stages of pull-down modules, a switching transistor at each stage is cascaded sequentially, and a pull-down module at each stage is arranged between two adjacent stages of switching transistors. A pull-down module at each stage includes two cascaded NMOS transistors.

As an example, as shown in FIG. 7, chips on which the single pole triple-throw switch is disposed include one first chip 22 and three second chips 23a, 23b, and 23c. The first switch path 21a, the second switch path 21b, and the third switch path 21c are each divided into a first part and a second part. Each first part includes two stages of switching transistors and two stages of pull-down modules, and each second part includes three stages of switching transistors and two stages of pull-down modules. The first part of each switch path is arranged on the first chip 22, the second part of the first switch path 21a is arranged on the second chip 23a, the second part of the second switch path 21b is arranged on the second chip 23b, and the second part of the third switch path 21c is arranged on the second chip 23c. Since a structure of each second part is the same, each of the second chips is of the same type.

As another example, as shown in FIG. 8, chips on which the single pole triple-throw switch is disposed include one first chip 22 and three second chips 23a, 23b, and 23c. The first switch path 21a, the second switch path 21b, and the third switch path 21c are each divided into a first part and a second part. The first part of the first switch path 21a includes one stage of switching transistor and one stage of pull-down module, and the second part of the first switch path 21a includes four stages of switching transistors and three stages of pull-down modules. The first part of the second switch path 21b includes two stages of switching transistors and two stages of pull-down modules, and the second part of the second switch path 21b includes three stages of switching transistors and two stages of pull-down modules. The first part of the third switch path 21c includes three stages of switching transistors and three stages of pull-down modules, and the second part of the third switch path 21c includes two stages of switching transistors and one stage of pull-down module. The first part of each switch path is arranged on the first chip 22, the second part of the first switch path 21a is arranged on the second chip 23a, the second part of the second switch path 21b is arranged on the second chip 23b, and the second part of the third switch path 21c is arranged on the second chip 23c. In this example, each of the second chips is a different chip.

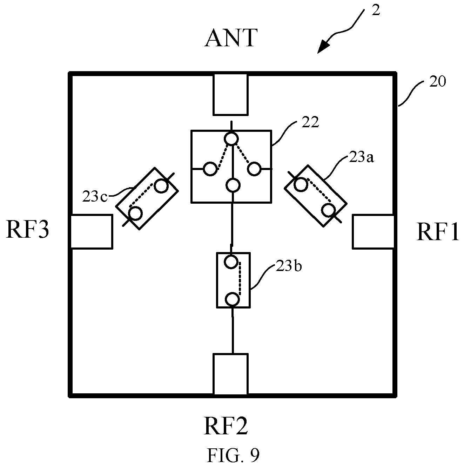

As shown in FIG. 9, ends of the first parts of the switch paths on the first chip 22 are connected together to serve as a movable contact, and the other ends of the first parts of the switch paths on the first chip 22 are respectively connected to ends of corresponding second parts on the second chips. The other ends of the second parts on the second chips serve as stationary contacts. Electrical connections between the chips are achieved via a metal lead or a substrate. A size of the first chip is greatly reduced, and positions of the second chips may be set as needed. Therefore, low cost and high isolation may be effectively balanced.

It should be noted that the second parts of the switch paths may be disposed on a single second chip; circuit structures of the first parts of the switch paths may be set differently, and circuit structures of the second parts of the switch paths may also be set differently. Of course, each switch path may also be split into three or more parts that are disposed on different chips (for example, a third chip, a fourth chip...), a complete switch path is obtained by sequentially connecting through the first chip, the second chip, the third chip..., and details are not repeated here.

In summary, the present invention may satisfy isolation requirements of the pads by arranging a position of each chip, and electrical connections between the chips via the metal lead or the substrate achieve a circuit structure of the single pole N throw switch 21. At the same time, chip area may be greatly reduced. In a solution, with the circuit structure being exactly the same, a total area of the chips in the split switch structure of the present invention is reduced to 40% of that of the single pole multi-throw switch in FIG. 1. A splitting method of the single pole N throw switch of the present invention needs to be determined based on application scenarios, performance requirements, packaging requirements, cost, and so on. There are no absolute limitations on quantity or form. Any solution that splits the single pole N throw switch 21 and arranges the parts on different chips falls within the protection scope of the present invention, and details are not repeated here.

The present invention also provides an electronic product, and the electronic product at least includes: the split switch structure 2 of the present invention. The electronic product includes, but is not limited to, an electronic switch and a communication device, which is not elaborated here.

The present invention also provides a base station, the base station is provided with a radio frequency switch unit, and the radio frequency switch unit includes the radio frequency switch described above. The radio frequency switch unit includes but is not limited to a radio frequency switch, a data receiving subunit and a transmitting subunit, and so on, which is not elaborated here.

In summary, the present invention provides a split switch structure, a radio frequency switch, an electronic product, and a base station, including: a single pole N throw switch, where N is a natural number greater than or equal to 1; the single pole N throw switch includes N switch paths, each switch path is switched through turn-on and turn-off of a switching transistor, and devices of the single pole N throw switch are at least arranged on two chips; and pads corresponding to contacts of the single pole N throw switch satisfy isolation requirements in terms of distance. In the split switch structure and the electronic product of the present invention, splitting the devices of the single-pole multi-throw switch onto at least two chips reduces chip area and cost, and isolation is improved through flexible spatial arrangement, thereby achieving both high isolation and low cost, thus making it suitable for large-scale production and application. Therefore, the present invention effectively overcomes various shortcomings in the prior art and has high industrial utilization value.

The above embodiments are only illustrative of the principles and effects of the present invention and are not intended to limit the present invention. Anyone skilled in the art may modify or change the above embodiments without departing from the spirit and scope of the present invention. Therefore, all equivalent modifications or changes made by those with ordinary knowledge in the technical field without departing from the spirit and technical ideas disclosed in the present invention shall still be covered by the claims of the present invention.

## Claims

1. A split switch structure, **characterized in that** the split switch structure comprises:
a single pole N throw switch, where N is a natural number greater than or equal to 1; and the single pole N throw switch comprises N switch paths, each switch path is switched through turn-on and turn-off of a switching transistor, and devices of the single pole N throw switch are at least arranged on two chips.

2. The split switch structure according to claim 1, wherein at least one of the switch paths is located on at least two chips.

3. The split switch structure according to claim 1, wherein each of the chips comprises: at least two pads, and the pads are configured to electrically connect the chip to another chip or to a package housing.

4. The split switch structure according to claim 1, wherein the split switch structure further comprises a package housing, the single pole N throw switch is arranged within the package housing, and each pad of the single pole N throw switch is electrically connected to a corresponding pin on the package housing.

5. The split switch structure according to claim 1, wherein each switch path comprises M stages of switching transistors, where M is a natural number greater than or equal to 1; and in a switch path where a number of switching transistors, M, is greater than or equal to 2, a switching transistor at each stage is cascaded sequentially.

6. The split switch structure according to claim 5, wherein each switch path further comprises: m stages of pull-down modules, where m is a natural number greater than or equal to 0 and less than or equal to M+1, an end of each pull-down module is connected to an end of a corresponding switching transistor, and another end of the pull-down module is grounded or connected to a specific impedance; and, a number of switching transistors, M, in each switch path is the same or different, and a number of pull-down modules, m, in each switch path is the same or different.

7. The split switch structure according to claim 6, wherein each of the pull-down modules comprises P stages of transistors, where P is a natural number greater than or equal to 1, and in a pull-down module where a number of transistors, P, is greater than or equal to 2, a transistor at each stage is connected in series sequentially; and a number of transistors, P, in each pull-down module is the same or different.

8. The split switch structure according to claim 7, wherein the switching transistor is an NMOS transistor, and the transistor in the pull-down module is an NMOS transistor.

9. The split switch structure according to any one of claims 1 to 8, wherein N is greater than or equal to 2, the N switch paths are arranged on at least two chips, and a same switch path is located on a same chip.

10. The split switch structure according to claim 9, wherein n1 switch paths of the single pole N throw switch are arranged on a first chip, and n2 switch paths are arranged on a second chip; and n1 + n2 = N, where n1 is a natural number greater than or equal to 1 and less than N.

11. The split switch structure according to claim 10, wherein n2 is greater than or equal to 2, a number of second chips is n2, and taking a switch path as a unit, the n2 switch paths are respectively arranged on n2 second chips in a one-to-one correspondence.

12. The split switch structure according to any one of claims 1 to 8, wherein at least one of the N switch paths is split into at least two parts, and each part of the at least two parts is located on a different chip.

13. The split switch structure according to claim 12, wherein n3 switch paths of the single pole N throw switch are arranged on a first chip; n4 switch paths are each divided into a first segment and a second segment, the first segment of each switch path of the n4 switch paths is arranged on the first chip, and the second segment of each switch path is arranged on a second chip; and n3 + n4 = N, where n4 is a natural number greater than or equal to 1 and less than or equal to N.

14. The split switch structure according to claim 13, wherein the first segment and the second segment of each switch path are connected in series, and ends of the N switch paths on the first chip are connected together.

15. The split switch structure according to claim 14, wherein N and n4 are both greater than or equal to 2, a number of second chips is n4, and taking a switch path as a unit, the n4 switch paths are respectively arranged on n4 second chips in a one-to-one correspondence.

16. The split switch structure according to claim 10 or 14, wherein a circuit structure on each second chip is identical.

17. The split switch structure according to claim 1, further comprising: a metal lead or a substrate, configured to electrically connect different chips.

18. The split switch structure according to any one of claims 1 to 8, wherein pins on the package housing comprise one antenna pin and N radio frequency pins.

19. A radio frequency switch, **characterized in that** the radio frequency switch at least comprises: the split switch structure according to any one of claims 1 to 18.

20. An electronic product, **characterized in that** the electronic product at least comprises: a data receiving component and a data transmitting component, and both the data receiving component and the data transmitting component comprise: the radio frequency switch according to claim 19.

21. A base station, **characterized in that** the base station is provided with a radio frequency switch unit, and the radio frequency switch unit at least comprises the radio frequency switch according to claim 19.
